# EUROPEAN PATENT SPECIFICATION

(11) **EP 1 724 828 B1**
(45) Date of publication and mention of the grant of the patent: **21.04.2010**
(21) Application number: 06114045.5
(22) Date of filing: 16.05.2006
(51) Int. Cl.: H01L 21/8234, H01L 21/8238, H01L 21/28, H01L 27/092

(54) **Method for forming dual fully silicided gates and devices obtained thereby**
Verfahren zur Herstellung vollsilicidierter Dual-Gates und mit diesem Verfahren erhältliche Halbleiterbauelemente
Procédé de fabrication de dispositifs à grilles différenciées complètement siliciurées et dispositifs obtenus

(30) Priority: 16.05.2005 US 681831 P; 14.07.2005 US 699179 P; 17.11.2005 JP 2005333128
(43) Date of publication of application: 22.11.2006
(73) Proprietor: IMEC, 3001 Leuven (BE); NXP B.V., 5656 AG Eindhoven (NL); Texas Instruments Incorporated, Dallas, Texas 75265 (US)
(72) Inventor: Kittl, Jorge Adrian, 1410, Waterloo (BE); Lauwers, Anne, 2630, Aartselaar (BE); Veloso, Anabela, 3001, Leuven (BE); Kottantharayil, Anil, 3000, Leuven (BE); Van Dal, Marcus Johannes Henricus, 3000, Leuven (BE)
(74) Representative: Venite-Aurore, Olessia

(56) References cited:
- US-A1- 2004 094 804
- US-A1- 2005 056 881
- AOYAMA T ET AL: "Proposal of new HfSiON CMOS fabrication process (HAMDAMA) for low standby power device" ELECTRON DEVICES MEETING, 2004. IEDM TECHNICAL DIGEST. IEEE INTERNATIONAL SAN FRANCISCO, CA, USA DEC. 13-15, 2004, PISCATAWAY, NJ, USA,IEEE, 13 December 2004 (2004-12-13), pages 95-98, XP010788705 ISBN: 0-7803-8684-1
- AIME D ET AL: "Work function tuning through dopant scanning and related effects in Ni fully silicided gate for sub-45nm nodes CMOS" ELECTRON DEVICES MEETING, 2004. IEDM TECHNICAL DIGEST. IEEE INTERNATIONAL SAN FRANCISCO, CA, USA DEC. 13-15, 2004, PISCATAWAY, NJ, USA,IEEE, 13 December 2004 (2004-12-13), pages 87-90, XP010788703 ISBN: 0-7803-8684-1
- TAKAHASHI K ET AL: "Dual workfunction Ni-silicide/HfSiON gate stacks by phase-controlled full-sificidation (PC-FUSI) technique for 45nm-node LSTP and LOP devices" ELECTRON DEVICES MEETING, 2004. IEDM TECHNICAL DIGEST. IEEE INTERNATIONAL SAN FRANCISCO, CA, USA DEC. 13-15, 2004, PISCATAWAY, NJ, USA,IEEE, 13 December 2004 (2004-12-13), pages 91-94, XP010788704 ISBN: 0-7803-8684-1

## Description

### Field of the invention

The present invention relates to semiconductor process technology and devices. In particular, the present invention relates to semiconductor devices with metallic gate electrodes formed by a reaction between a metal and a semiconductor material.

### Background

CMOS (Complementary Metal-Oxide-Silicon) devices comprise two types of transistors nMOS and pMOS, each transistor type having its own characteristics and properties. There is a trend to replace the semiconductor gate electrode with metal ones, as metal gate electrodes offer the advantages of reducing the sheet resistance, eliminating the semiconductor gate depletion effect, and controlling the work function independently from the doping of the junction regions.

Metal gate electrodes can be formed by full silicidation (FUSI) of the semiconductor gate electrode with a metal. The semiconductor gate electrode may be a polysilicon gate electrode. The metal may be a refractory metal such as W, noble metals such as Pt, near noble metals such as Ni, transition metals such as Ti, or any combination thereof. During this silicidation process, the gate electrode is converted into a silicide.

If high performing CMOS devices are to be obtained, the gate electrode work function should be different for each transistor type. Hence, a different gate electrode metal should be used for each transistor type yielding so-called dual metal gate or dual work function metal gate CMOS devices. Various manufacturing methods exist to form such dual metal gate CMOS devices using full silicidation of the semiconductor gate electrode. According to U.S. Patent No. 6,905,922, the FUSI gate electrode of nMOS and pMOS transistors respectively should be formed in separate silicidation steps. Although this approach allows different metals to be used for each transistor type, the number of process steps will increase and the first formed silicide will be subjected to the high temperature processing of the later formed silicide.

A. Veloso et al. discloses in "Work function engineering by FUSI and its impact on the performance and reliability of oxynitride and Hf-silicate based MOSFET's, in IEDM proceedings 2004 p855-858, the formation of fully silicided nMOS and pMOS transistors by depositing a single layer of nickel and forming a nickel-silicide by one or two anneal steps. The work function of the gate electrode can be engineered by doping of the polysilicon gate prior to the deposition of the nickel layer. However, this method only allows tuning the work function for gate electrodes formed on oxynitride gate dielectrics.

US 2005/0158996 discloses a method for forming a thermal stable Ni₁Si₁ on a substrate, i.e. source/drain junctions or a polysilicon gate to form a low resistive path on these junction regions (source/drain).

W. Maszara et al. discloses in "Transistors with Dual Work Function Metal Gates by Single Full Silicidation (FUSI) of Polysilicon gates" in IEDM proceedings 2002 p367-370, an alternative method to control the work function of a fully silicided gate electrode. According to this approach the FUSI gate of nMOS and pMOS transistors is formed during a single silicidation step using nickel as metal for both types of transistor. Due to the presence of dopants in the polysilicon gate electrode a different work function is obtained for nMOS and pMOS transistors respectively. Although this approach uses only one metal, the difference in work function between nMOS and pMOS transistors is determined by the dopants present in the semiconductor gate electrode prior to silicidation. Typically, the gate electrode is doped while doping the junction regions, which means that the work function of the thus formed transistor depends on the doping of its junction regions. If the doping of the gate electrode is to be selected independent from doping of the junction regions, additional masking and implantation steps are to be included in the process flow resulting in increased process costs and complexity.

Takahashi et al. discloses in "Dual Workfunction Ni-Silicide/HfSiON Gate Stacks by Phase-Controlled Full-silicidation (PC-FUSI) technique for 45nm-node LSTP and LOP devices," in IEDM proceedings 2004 p91-94, another dual metal gate alternative. According to this approach, different phases of nickelsilicide having different work functions are obtained by depositing on nMOS transistors and pMOS transistors respectively a thin and thick layer of nickel. During the subsequent anneal step the fully nickel-silicided gate electrodes should be formed having the corresponding phase. However the inventors found that, when applying the full silicidation technique of Takashi, a nickel-rich fully silicided gate electrode was obtained not only on pMOS transistors, but also on all transistors having small dimensions, including nMOS transistors with small gate lengths.

[0008a] Aoyama et al. describes in "Proposal of new HfSiON CMOS fabrication process (HAMDAMA) for low standby power device", in TEDM proceedings 2004 p95-98, the formation of dual gate transistors with poly-Si electrode for n-FET and NiSi electrode for p-FET on HfSiON/SiO2 gate stacks using a half-masked Damascene-like full silicidation (HAMDAMA) process.

Hence, there is need for a low complexity method for manufacturing dual metal gate CMOS devices in which the work function of the metal gate electrode of each transistor type can be engineered in an easy, efficient, and controllable way, independent of the geometry and/or dimensions of the transistor or of the gate dielectric used.

### Summary

The present invention relates to a method of manufacturing a dual fully-silicided-gate device, comprising providing at least two MOSFET devices each having a semiconductor gate electrode with a different thickness, depositing a metal layer, with a constant thickness, over each of said semiconductor gate electrode, performing a thermal process, wherein each semiconductor thickness is selected such that the semiconductor gate electrode is fully silicided, whereby said at least two MOSFET have a different work function.

The method can further comprise the dual fully-silicided-gate device being a CMOS device, and the MOSFET with the thicker semiconductor gate electrode is an nMOSFET and the MOSFET with the thinner semiconductor gate electrode is a pMOSFET.

In a method according to the invention said thermal process can comprise or consist of a first thermal process step to partially silicide said thicker semiconductor gate electrode, a step of removing the remaining, unreacted metal layer, a second thermal process step to fully silicide said thicker semiconductor gate electrode.

Said first and/or second thermal process step(s) is/are preferably RTP step(s).

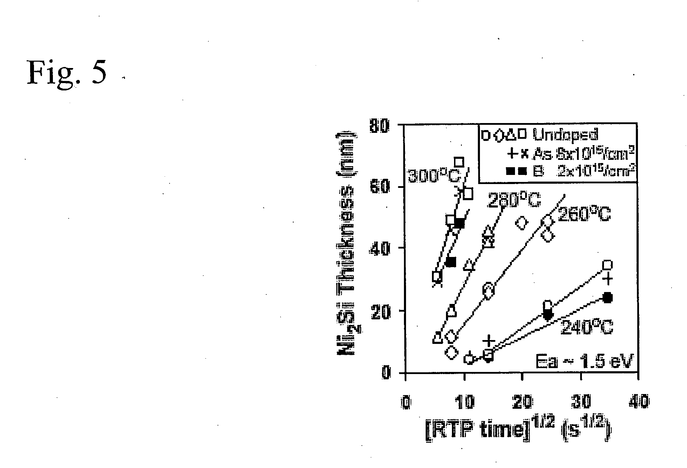

The temperature and time parameters of said first and/or second thermal step(s) can be determined for each silicide phase by establishing a silicidation kinetics graph, such as the Ni₂Si silicidation kinetics graph drawn up and represented in figure 5.

A method according to the invention can further comprise the silicide formed during (or resulting from) the first thermal step being a metal-rich silicide.

A method according to the invention can further comprise the metal-to-semiconductor atomic percentage ratio of the fully silicided gate electrode formed after said second thermal step being lower than the metal-to-semiconductor atomic percentage ratio of the partially silicided gate electrode formed after said first thermal step.

In particular, and having regard to said thicker semiconductor gate electrode, the silicide resulting from said first thermal process step is metal-richer than the silicide resulting from said second thermal process step.

More particularly, a metal-rich silicide is formed after said first thermal step.

For example a NiₓSi_{y} silicide with x/y ≥ 2 (more particularly with 2≤x/y≤3) is formed after said first thermal step. A fully silicided gate electrode can thus be formed after the second thermal step having, at least adjacent the gate dielectric (at the interface), a NiₓSi_{y} phase with 0<x/y≤1, preferably with x/y=1 (or with x/y substantially equal to 1).

A method of manufacturing a dual fully-silicided-gate device according to the invention can comprise the steps of providing a first MOSFET having a first semiconductor gate electrode with a thickness t_{Si1}; providing a second MOSFET having a second semiconductor gate electrode with a thickness t_{Si2}, wherein t_{Si2} < t_{Si1}; depositing a first metal layer having a thickness t_{M1} on the first semiconductor gate electrode of the first MOSFET; depositing a second metal layer having a thickness t_{M2} on the second semiconductor gate electrode of the second MOSFET; performing a first thermal process step to partially silicide the first semiconductor gate of the first MOSFET to form a silicide Mₓ₁S_{y1} and to fully silicide the second semiconductor gate of the second MOSFET to form a silicide Mₓ₂S_{y2}, removing the remaining, unreacted metal, and performing a second thermal process step to fully silicide said first semiconductor gate of said first MOSFET to form a silicide Mₓ₃S_{y3}.

Preferably, in a method according to the invention, x₂/y₂ is greater than x₃/y₃.

In a method of the invention said first thermal process step can comprise the steps of selecting a (suitable) thermal budget to partially silicide the first gate electrode of the first MOSFET and to fully silicide the second gate electrode of the second MOSFET.

Preferably, said first metal layer and said second metal layer have (substantially) the same composition and thickness (t_{M2} = t_{M1}).

Preferably, the silicide (phase) resulting from said first thermal process step is (substantially) the same for the first MOSFET and for the second MOSFET (i.e. x₁/y₁ ≈ x₂/y₂).

A method according to the invention can further comprise the thickness ratio t_{M1}/t_{Si1} and t_{M2}/t_{Si2} being selected such that the atomic percentage ratio metal-to-semiconductor (of a combined metal layer/semiconductor gate electrode), after said first thermal process step, is greater than one for the first MOSFET and greater than two for the second MOSFET.

More particularly, the atomic percentage ratio metal-to-semiconductor of the partially silicided first gate electrode of the first MOSFET is greater than one and less than two.

In a method for manufacturing a dual fully-silicided-gate device according to the invention, at least two MOSFET devices are provided, each device having a semiconductor gate electrode.

The thickness of the semiconductor gate electrode is different for each of the at least two MOSFETs, such that thickness of the semiconductor gate electrode for one of the at least two MOSFETs is larger than for another of the at least two MOSFETs.

The method also includes depositing a metal layer at least on the semiconductor gate electrodes; performing a first thermal process step to partially silicide the thicker semiconductor gate electrode of one of said at least two MOSFETs and to fully silicide the thinner semiconductor gate electrode of one of said at least two MOSFETs; selectively removing an unreacted fraction of the deposited metal; and performing a second thermal process step to fully silicide the partially silicided semiconductor gate electrode.

A method according to the invention is particularly useful for forming a dual fully-silicided-gate CMOS device in which the MOSFET with said thicker semiconductor gate electrode is a nMOSFET and the MOSFET with said thinner semiconductor gate electrode is a pMOSFET.

In a method according to the invention, during the first thermal step a metal-rich silicide is formed for both nMOSFET and pMOSFET, although only a part of the semiconductor gate electrode of the nMOSFET is silicided.

During the second thermal step the partial silicided gate electrode of the nMOSFET is fully silicided. A ratio of a metal-to-semiconductor atomic percentage of this fully silicided gate electrode is lower than a ratio metal-to-semiconductor atomic percentage of the starting partially silicided gate electrode.

In one example, the semiconductor gate electrode comprises silicon and the metal layer comprises nickel. The metal-rich silicide formed during the first thermal step is an NiₓSi_{y} silicide with x/y ≥ 2 (more particularly with 2≤x/y≤3). The silicide of the fully silicided gate electrode formed during the second thermal step is a NiₓSi_{y} silicide with 0<x/y≤1, preferably with x/y=1 (or with x/y substantially equal to 1).

A method for manufacturing a dual fully-silicided-gate device according to the invention can also be described as follows. The method includes providing a first MOSFET having a first semiconductor gate electrode with thickness t_{Si1} and providing a second MOSFET having a second semiconductor gate electrode with thickness t_{Si2}. The thicknesses have the following relationship: t_{Si2} < t_{Si1}.

The method also includes depositing a first metal layer having a thickness t_{M1} on the semiconductor gate electrode of the first MOSFET; depositing a second metal layer having a thickness t_{M2} on the semiconductor gate electrode of the second MOSFET; performing a first thermal process step to partially silicide the first semiconductor gate of the first MOSFET to form a silicide Mₓ₁S_{y1}; and to fully silicide the second semiconductor gate of the second MOSFET to form a silicide Mₓ₂S_{y2}; selectively removing an unreacted fraction of the deposited metal; and performing a second thermal process step to fully silicide the partially silicided first semiconductor gate electrode to form a silicide Mₓ₃S_{y3}.

For the first MOSFET, an atomic percentage ratio metal-to-semiconductor of the silicide formed during the first thermal step x₂/y₂ is larger than then an atomic percentage ratio metal-to-semiconductor of the silicide formed during the second thermal step x₃/y₃. A thermal budget of the first thermal step is selected to partially silicide the gate electrode of the first MOSFET and to fully silicide the gate electrode of the second MOSFET.

In one embodiment the first and second metal layer have substantially the same composition and thickness: t_{M2} ≈ t_{M1} and, during the first thermal step, substantially the same silicide is formed for the first and second MOSFET such that the atomic percentage ratio metal-to-semiconductor of the silicides formed is substantially the same: x₁/y₁ ≈ x₂/y₂.

Preferably, the atomic percentage ratio metal-to-semiconductor of the silicides formed during the first thermal step is larger than 1: x₁/y₁ ≈ x₂/y₂ >1. Preferably, the atomic percentage ratio metal-to-semiconductor of the silicide of the first MOSFET formed during the first thermal step is larger than 2: x₂/y₂ >2. Preferably, the atomic percentage ratio metal-to-semiconductor of the silicide of the first MOSFET formed during the second thermal step is about 1: x₃/y₃ ≈ 1.

Preferably, the thickness ratio t_{M1}/t_{Si1} and t_{M2}/t_{Si2} of the unreacted metal layer and of semiconductor gate electrode are selected such that the atomic percentage ratio metal-to-semiconductor of the combined metal layer/semiconductor gate electrode is greater than 1 for the first MOSFET and greater than 2 for the second MOSFET. After silicidation, the atomic percentage ratio metal-to-semiconductor of the partially silicided gate electrode of the first MOSFET is greater than 1 and less than 2.

In one embodiment the semiconductor gate electrode of the first and second MOSFET comprises silicon and the first and the second metal layer comprises nickel.

These as well as other aspects and advantages will become apparent to those of ordinary skill in the art by reading the following detailed description, with reference where appropriate to the accompanying drawings.

### Brief description of the drawings

Exemplary embodiments are illustrated in referenced figures of the drawings. It is intended that the embodiments and figures disclosed herein be considered illustrative rather than restrictive. Same numerals are used to refer to corresponding features in the drawings.

Figure 1a is a graph that shows a variation in workfunction Φm (eV) with the thickness ratio tNi/tSi of the nickel/silicon layers before silicidation, for nickel silicide layer formed on a hafnium-silicon-oxynitride dielectric for large devices.
Figure 1b is a graph that shows a variation in work function WF (eV) of several nickel silicides formed either on a silicon-oxide (SiO2) dielectric layer or on a hafnium-silicon-oxynitride (HfSiON) dielectric layer. The nickel silicides differ in the atomic percentage of nickel present.

Figures 2a-d are cross sections that show various steps of a process flow, according to an example.

Figure 3a-e are cross sections that show various steps of a process flow, according to another example.

Figures 4a-d are cross sections that show various steps of a process flow, according to another example.

Figure 5 is a graph that shows Ni₂Si silicidation kinetics, according to an example.

Figure 6 is a graph that shows silicide growth rates for NiSi and Ni₂Si, according to an example.

Figure 7 is a graph that shows a process window for a first thermal process step, according to an example.

Figures 8a-e are cross sections that shows various steps of a process flow, according to an example.

Figure 9 shows XRD (Cu K_{α} radiation) characterization of Ni silicide films as function of RPT1 temperature according to an example.

Figure 10 shows the reacted nickel to silicon ratio of Ni silicide films as function of the RPT1 temperature according to an example.

Figure 11 shows nickel silicide phase formation as function of the temperature of the first anneal step and of the thickness of the polysilicon layer according to an example.

Figure 12 shows as function of the gate length for nMOS and pMOS transistors the influence of the nickel silicide phase on a) the threshold voltage and b) on the drive current (Idsat) and on the off-current (leakage at drain junction: Ioff) according to an example.

Figure 13 shows the work function (WF) and threshold voltage (Vtlin) of a pMOS transistor as function of the atomic percentage nickel in the fully silicided nickel silicide gate electrode according to an example.

### Detailed description

For selected metal-semiconductor alloys, i.e. silicides, the work function thereof may depend on the specific phase in which the alloy is formed. Hence, the suitability of such metal-semiconductor combinations as gate electrode for one type of transistor depends on which phase of this combination can be formed for this type of transistor. Said specific phase is to be formed at least at the bottom part of the gate electrode, the last few nanometers of the gate electrode (e.g. the last nanometer, or the last 2, 3, 4, 5, 10 nanometers or even more), i.e. at least at the part which is the nearest to the gate dielectric, also referred to in the present invention as the "interface".

In other words, in the context of the present invention, the term "interface", when referring to the silicide phase of the gate electrode, refers to the bottom part of the gate electrode (which is the nearest to the gate dielectric), of few nanometers thickness, e.g. between about 1 nm and about 10 nm, preferably between about 1 nm and about 5 nm.

In a method according to the invention, said metal layer can be of any metal(s), preferably capable of diffusing into the underlying semiconductor material, suitable for metal gate electrodes.

More particularly, said metal layer can comprise or consists of a refractory metal such as tantalum or tungsten, a noble metal such as Pt, a near noble metal such as Ni, a transition metal such as Ti, or any combination of two or more of these metals.

Said semiconductor layer can be of any material(s) suitable for metal gate electrodes. More particularly, said semiconductor layer can comprise or consists of Si, Ge or a mixture thereof.

For example, and in particular at least at the interface, metal-rich phases such as Ni₂Si, Ni₃Si₂, Ni₃₁Si₁₂, or Ni₃Si may be more suitable as FUSI gate electrode material for pMOS transistors, while metal-poor phases such as NiSi or NiSi₂ may be more suitable as FUSI gate electrode material for nMOS.

In the framework of the present invention, the terms "silicide", "silicided", "silicidation" can refer to the reaction between a metal and silicon, but is not intended to be limited to silicon. For instance, the reaction of a metal with Ge, or any other suitable semiconductor material, may still be referred to as silicidation.

In the framework of the present invention, the term "metal-rich silicide" refers to the material resulting from the reaction between said metal and said semiconductor, wherein the ratio metal-to-semiconductor is larger than 1.

Said silicide phase (also referred to as metal-semiconductor phase) can be represented by the formula MₓS_{y}, wherein M represents the metal, S represents the semiconductor and wherein x and y are integers or real numbers different from 0. In a metal-rich silicide, x/y is larger than 1.

More particularly, having regard to nickel silicide, for metal-rich phases such as Ni₂Si, Ni₃Si₂, Ni₃₁Si₁₂, or Ni₃Si, the ratio x/y is higher than 1 and preferably less than or equal to 3 (i.e. 1<x/y≤3), while for metal-poor phases such as NiSi or NiSi₂, the ratio x/y is higher than 0 and less than or equal to 1 (i.e. 0<x/y≤1).

It is possible to obtain a specific silicide phase for a specific type of transistor by selecting for each type of transistor a thickness ratio t_{M/}t_{Si} of metal and semiconductor material present prior to the silicidation process when sufficient thermal budget is provided to drive the reaction to completion. In the approach explored by Takahashi et al in "Dual Workfunction Ni-Silicide/HfSiON Gate Stacks by Phase-Controlled Full-silicidation (PC-FUSI) technique for 45nm-node LSTP and LOP devices", in IEDM proceedings 2004 p91-94, the thickness of the metal film was used to select the thickness ratio t_{M}/t_{Si} and hence the silicide phase to be formed. This has the disadvantage that an accurate control of the thickness of the nickel layer formed is needed in order to obtain the desired thickness ratio. Even if a well-controlled nickel layer would be formed, for transistors with small dimensions, the effective nickel-to-silicon ratio would be more than the one determined on the layer thickness ratio given above, as excess nickel, originating from regions adjacent such small gate electrode, will diffuse towards the polysilicon gate electrode during the thermal process step and add to the effective nickel amount available during silicidation.

The present invention discloses in a first embodiment a method to form a fully silicided gate electrode for both nMOS and pMOS transistors using one metal layer, but wherein the thickness of the semiconductor gate electrode prior to the deposition of this metal layer is different for nMOS and pMOS transistors. For the same amount of metal deposited on the semiconductor gate electrode of each type of transistor on the same wafer, different phases can be formed for each transistor type depending on the amount of semiconductor material available at the gate electrode: the less semiconductor material present, the more metal-rich the silicide will be.

Therefore, by selecting the amount of the semiconductor material of the gate electrode for each type of transistor, e.g. by selecting the thickness of the semiconductor gate electrode, one can form different silicide phases of the metal-semiconductor combination, at least at the interface, during the same silicidation process, hence, creating two gate electrodes having a different work function in one silicidation process.

Optionally, the thickness (t_{M}) of the metal present for each type of transistor can also be different (t_{M1}, t_{M2}), as long as for each type of transistor the atomic ratio metal-semiconductor is such as to form the respective phases, at least at the interface, for each type of transistor.

In order to obtain a high thickness ratio t_{M}/t_{Si} for one type of transistor the amount of semiconductor material available on the corresponding gate electrode is reduced allowing a thinner layer of metal to be used. Consequently, less excess metal will be present near the other transistor type where a low thickness ratio t_{M}/t_{Si} is desired. Especially, for transistors having smaller lengths or widths, the volume of metal surrounding the gate electrode, in comparison with the volume of metal present upon the gate electrode, i.e. on top of the semiconductor gate electrode, cannot be neglected in case thicker layers of metal are used.

For the purpose of teaching the invention, nickel (Ni) is used as metal and silicon (Si) as semiconductor material. The capability of tuning the work function of FUSI gate electrodes by forming different Nisilicide phases, at least at the interface, for each type of transistor is very attractive for CMOS integration. To achieve this, the effective atomic ratio nickel to silicon as expressed e.g. by the thickness ratio t_{Ni}/t_{Si} of the nickel/silicon layers before silicidation has to be different for nMOS and for pMOS transistors.

If a NiSi gate electrode is to be formed for nMOS transistors this thickness ratio t_{Ni}/t_{Si} should be less than 1.1 and preferably comprised between 0.55 and 0.8.

If a Ni-rich gate electrode is to be formed for pMOS transistors this thickness ratio t_{Ni}/t_{Si} preferably is larger than 1.1.

For Ni/Si thickness ratios of 0.6, 0.9, 1.2, 1.4, and 1.7 respectively the NiSi, Ni₃Si₂, Ni₂Si, Ni₃₁Si₁₂, and Ni₃Si phase can be obtained at the interface between the gate electrode and the gate dielectric.

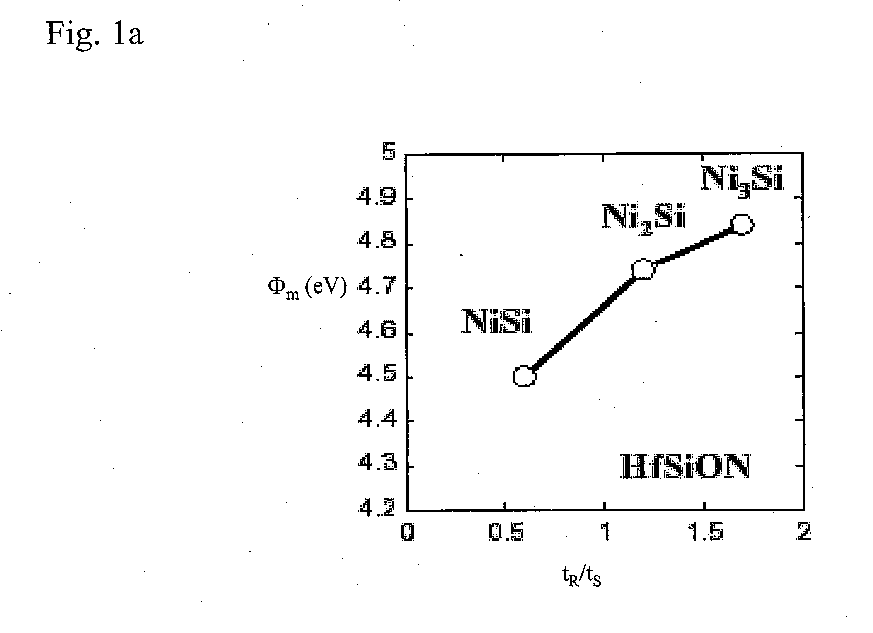

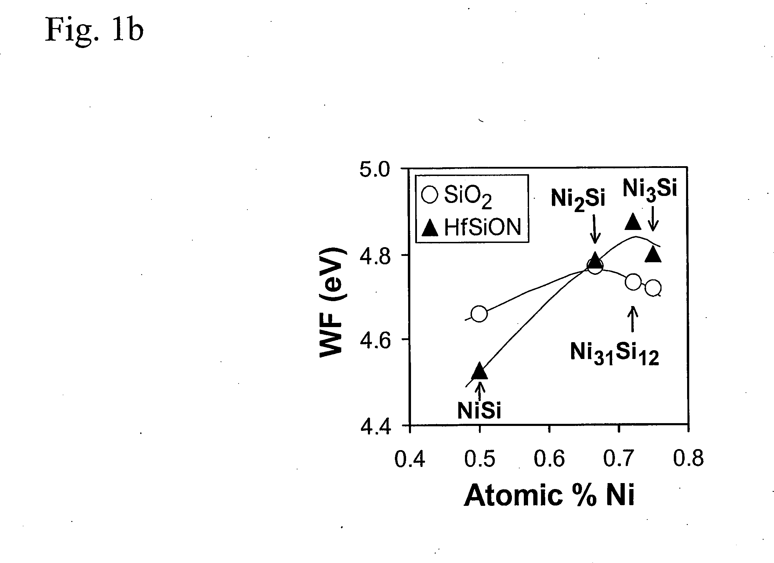

As shown in Figures 1a and 1b, the work function of the silicon/nickel combination increases with increasing thickness ratio or in other words with increasing nickel content: (about) 4.5 eV for NiSi, (about) 4.74 eV for Ni₂Si, and (about) 4.86 eV for Ni₃Si.

A method of manufacturing a dual fully-silicided-gate device is provided, comprising the steps of:
- providing at least two MOSFET devices each having a semiconductor gate electrode with a different thickness (said semiconductor gate electrode being formed on a gate dielectric),
- depositing a metal layer, with a constant thickness (t_{M}) (i.e. same thickness), over each of said semiconductor gate electrode,
- performing a thermal process, preferably a RTP,
wherein each semiconductor thickness (Tₛᵢ) is selected such that the semiconductor gate electrode is fully silicided, whereby said at least two MOSFET have a different work function.

This method is of particular use to control the semiconductor-metal phase formed as gate electrode, at least at the interface, for large devices.

For small devices, i.e. typically smaller than 100 nm, the effective metal-to-semiconductor ratio might be larger than expected from the thickness ratio t_{M}/t_{Si}. Whereas in large device substantially all of the metal participating in the silicidation process stems from the metal layer above the gate electrode, in small devices a relevant amount of the metal, e.g. 10% or more, 25% or more originates from metal outside the area of the gate electrode. This relevant amount is sufficient to form the next metal rich phase than the one envisaged based on the thickness ratio.

In a preferred embodiment the present invention therefore combines the teaching of the first embodiment with the use of a two-steps silicidation process.

In other words, according to a preferred method of the invention, said thermal process comprises or consists of a first thermal process step and a second thermal process step.

The two-steps silicidation process of the present invention comprises depositing a layer of metal over the exposed semiconductor gate electrode, performing a first thermal process step, selectively removing unreacted metal, and performing a second thermal process step.

A method of manufacturing a dual fully-silicided-gate device according to the invention, comprises the steps of:
- providing at least two MOSFET devices each having a semiconductor gate electrode with a different thickness formed on a gate dielectric,
- depositing a metal layer, with a constant thickness, over each of said semiconductor gate electrode,
- performing a first thermal process step to partially silicide the thicker semiconductor gate electrode and to fully silicide the thinner semiconductor gate electrode,
wherein the silicide formed has a ratio metal-to-semiconductor larger than 1,
- removing the remaining, unreacted metal layer,
- performing a second thermal process step to fully silicide said thicker semiconductor gate electrode,
whereby said at least two MOSFET have a different work function.

In particular, where the metal is Ni and the semiconductor Si, the two-steps silicidation process of the present invention comprises depositing a layer of nickel over the exposed silicon gate electrode, performing a first thermal process step, selectively removing unreacted nickel, and performing a second thermal process step.

The thickness ratio t_{Ni}/t_{Si} is preferably in the range 0.54 to 3. The thickness t_{Ni} of the as-deposited nickel layer is preferably in the range 10 nm to 200 nm, while the thickness t_{Si} of the as-deposited silicon gate electrode preferably is in the range of 20 nm to 300 nm.

The parameters of the first thermal process step are selected to form a metal (preferably Ni) rich phase on both nMOS and pMOS transistors. Due to the difference in semiconductor (preferably silicon) thickness, the semiconductor (preferably silicon) of the pMOS gate electrode is fully silicided, while the semiconductor (preferably silicon) of the nMOS gate electrode is only partially silicided such that a semiconductor (preferably silicon) layer remains between the gate dielectric and the silicided part.

Furthermore, appropriate tuning of the first thermal step assists in avoiding full silicidation of the nMOS gate electrode even for small transistors where abundant metal (preferably nickel) might be available near the gate electrode. The thermal budget of the first thermal process step is selected to fully consume the semiconductor (preferably silicon) of the pMOS transistor while the semiconductor (preferably silicon) of the nMOS transistor is only partially consumed such that enough metal (preferably nickel) is incorporated in the nMOS gate electrode, i.e. sufficient metal-rich silicide (preferably Ni-rich silicide) is formed, to allow full silicidation of this nMOS gate electrode during the second thermal process step.

Said first thermal process step can be done using Rapid Thermal Processing (RTP), in which case the temperature and duration of this first thermal process step ranges from (about) 240°C to (about) 700°C, preferably from (about) 250° to (about) 675°C, more preferably from (about) 250°C to (about) 450°C, even more preferably from (about) 350°C to (about) 450°C, and from 15 sec. to 60 sec.

Other sources of thermal energy are also known in the art, such as spike anneal, laser anneal, and furnace anneal.

Preferably, a selective etch is performed to remove unreacted nickel selectively with respect to the silicide. In particular any excess metal present near the nMOS transistor will also be removed during this removal step.

Thereafter, said second thermal process step is performed to convert the remaining semiconductor (preferably silicon) of the nMOS gate electrode, thereby forming a metal-poor fully silicide (preferably a Ni-poor fully silicide) gate electrode, more particularly at least at the interface.

The silicide of the pMOS gate electrode is unaffected during the second thermal process step since no semiconductor (preferably silicon) is left for further reaction with the metal (preferably nickel).

Said second thermal process step can be done using Rapid Thermal Processing (RTP), in which case the temperature and duration of this second thermal process step typically ranges from 350°C to 700°C and from 15 sec. to 60 sec.

Other sources of thermal energy are also known in the art, such as spike anneal, laser anneal, and furnace anneal.

In order to manufacture CMOS devices, the thickness of the semiconductor layer (preferably polysilicon layer) and of the metal layer (preferably nickel layer) and the thermal budget, i.e. time and temperature of the first thermal step, are selected such that during the first thermal step the gate electrode of the pMOS (4) device is fully silicided, with the selected metal-rich phase at least at the gate interface, while the gate electrode of the nMOS (3) is only partially silicided.

The ratio as-deposited metal/semiconductor (preferably nickel/silicon) of the pMOS devices is higher than the ratio as-deposited metal/semiconductor (preferably nickel/silicon) of the nMOS devices by reducing (e.g. etching back) the semiconductor layer (preferably poly-Si) thickness of the pMOS devices (4) relative to the semiconductor layer (preferably poly-Si) thickness of the nMOS devices (3).

The parameters of the second thermal step are selected to fully silicide the partially silicided gate electrode of the nMOS device (3), obtaining the selected metal-poor silicide, at least at the interface.

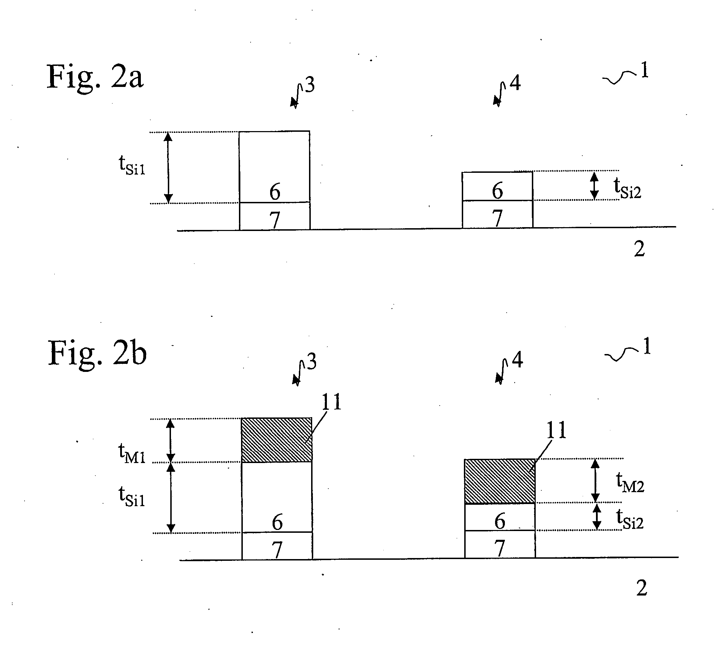

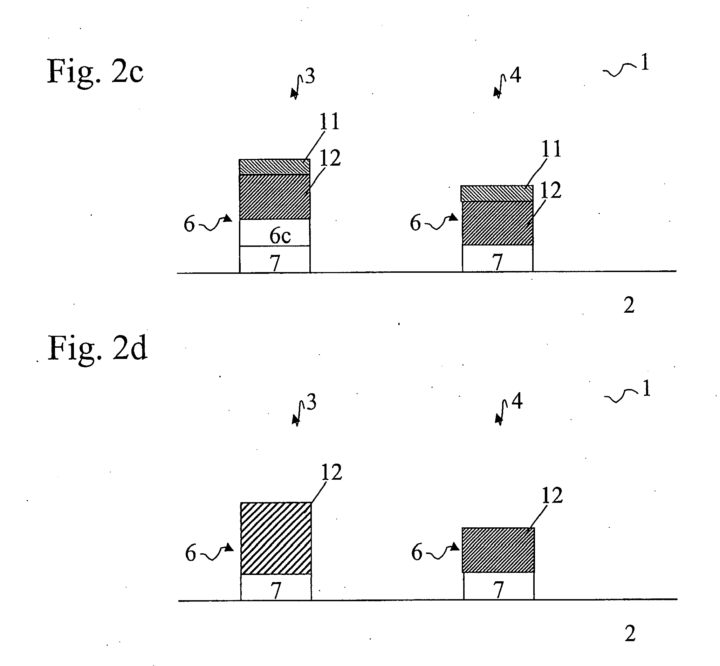

Figures 2a-d illustrate the above process sequence. Figure 2a shows the gate stacks of two transistors (3, 4), each gate comprising a semiconductor gate electrode (6) and a gate dielectric (7) formed on the same substrate (2). The thickness of the semiconductor gate electrode is larger for the left transistor (3): t_{Si1}> t_{Si2}.

Various methods are known in the art to create topography in a semiconductor layer such that gate electrodes (6) with different thickness are formed from the same semiconductor layer. For example, U.S. Patent No. 6,855,605 teaches a method to form removable parts in a semiconductor layer, which parts can then be removed later in the processing, thereby creating topography in the semiconductor layer.

On top of each gate electrode, a metal (11) is deposited having a thickness t_{M}. In this example, the metal thickness is the same (t_{M1} = t_{M2}) for both transistors (3, 4) as shown in Figure 2b.

During the first thermal process step, a metal-rich silicide is formed, which in the case of the thin semiconductor layer (tₛᵢ₂) replaces this gate electrode, while for the thicker semiconductor layer (t_{Si1}) still a bottom part (6c) of the original semiconductor layer remains near the gate dielectric (7). As shown in Figure 2c, some excess metal (11) can remain for the left transistor.

After selectively removing the unreacted fraction of the metal (11), the gate electrode of the left transistor (3) is completely silicided, thereby converting the stack of metal-rich silicide top layer and semiconductor bottom layer into a metal-poor silicide gate electrode (12).

Optionally, the semiconductor gate electrode can be doped prior to silicidation to allow further tuning of its work function. For one type of silicide phase obtained, the corresponding work function can be modified by the type and amount of dopant present in the semiconductor gate electrode before fully silidation thereof. Kedzierski et al teaches in "Metal-gate FinFET and fully depleted SOI devices using total gate silicidation", proceedings IEDM 2002 p 247, the effect of substitional dopants on the work function of NiSI FUSI gate electrode.

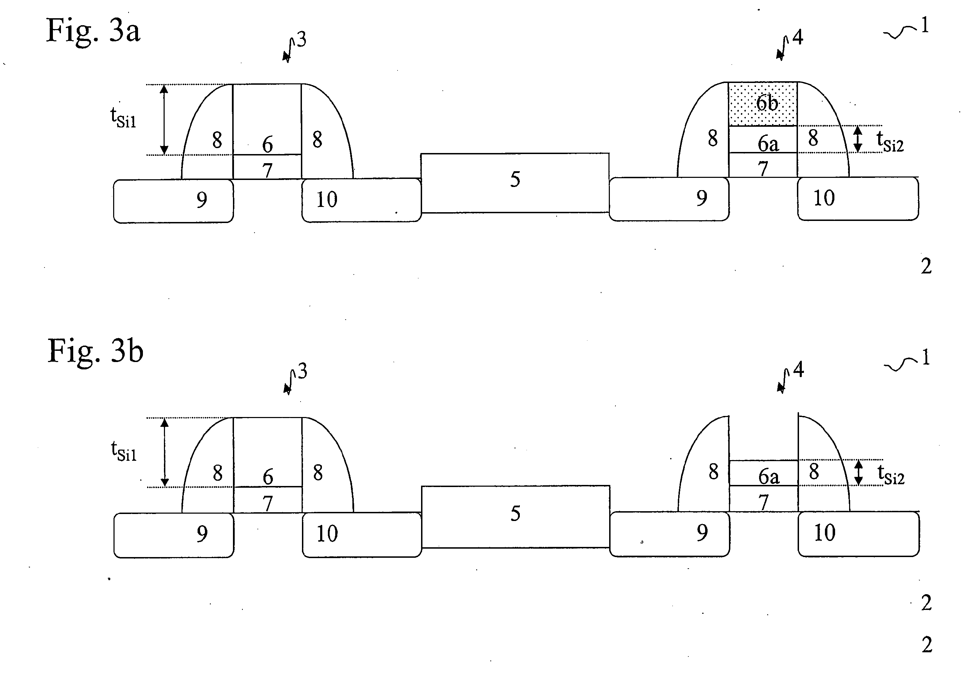

Figures 3a-e schematically illustrate a process flow according to an example. Figure 3a shows a CMOS device (1) formed on a substrate (2). The CMOS device comprises at least one nMOS transistor (3) and at least one pMOS transistor (4). Each transistor comprises a gate electrode (6), a gate dielectric (7) in-between the gate electrode (6) and the substrate (2), sidewall spacers (8) formed in a dielectric material adjacent the stack of gate electrode (6) and gate dielectric (7), source (9) and drain (10) junction regions aligned to the gate stack (6, 7) and extending underneath the sidewall spacers (8). Isolation structures (5) are provided to isolate the nMOS transistor (3) from the pMOS transistor (4).

The transistor (3, 4) shown in Figure 3a can be any type of Metal-Oxide-Semiconductor Field-Effect-Transistor (MOSFET), such as a bulk transistor or a Multiple Gate transistor (MuGFET).

The gate dielectric (7) can be a siliconoxide, a siliconoxynitride, a high-k dielectric, such as hafniumoxides, hafniumsilicates, and alumina-oxides, as known in the art.

The gate electrode (6) is formed in a semiconductor material, such as silicon and silicon-germanium.

As shown in Figure 3a, the gate electrode (6) of the nMOS transistor (3) is preferably formed of a single semiconductor material, such as polycrystalline silicon, having a thickness t_{S1}, while the gate electrode (6) of the pMOS (4) transistor comprises a stack of at least two layers (6a, 6b). These at least two layers (6a, 6b) are formed in different materials, which are selected such that the exposed layer (6b) can be selectively removed.

The substrate (2) can be a bulk semiconductor substrate (e.g. silicon or germanium wafer) or a semiconductor-on-insulator substrate (e.g., Silicon-On-Insulator (SOI), Germanium-In-Insulator (GeOI)).

The CMOS device shown in Figure 3a can be manufactured by standard semiconductor processes as known and appreciated by any person skilled in the art.

In the next process step illustrated in Figure 3b, the top layer (6b) of the pMOS (4) gate electrode is selectively removed such that the semiconductor layer (6a) is exposed. Preferably, this top layer (6b) is formed from SiGe while the bottom layer (6a) is formed from polycrystalline silicon. This material is preferably also used to form the gate electrode (6) of the nMOS transistor (3). A dry etch process is used to remove the SiGe plug (6b) such that a semiconductor layer (6a) having the predetermined thickness t_{Si2} remains.

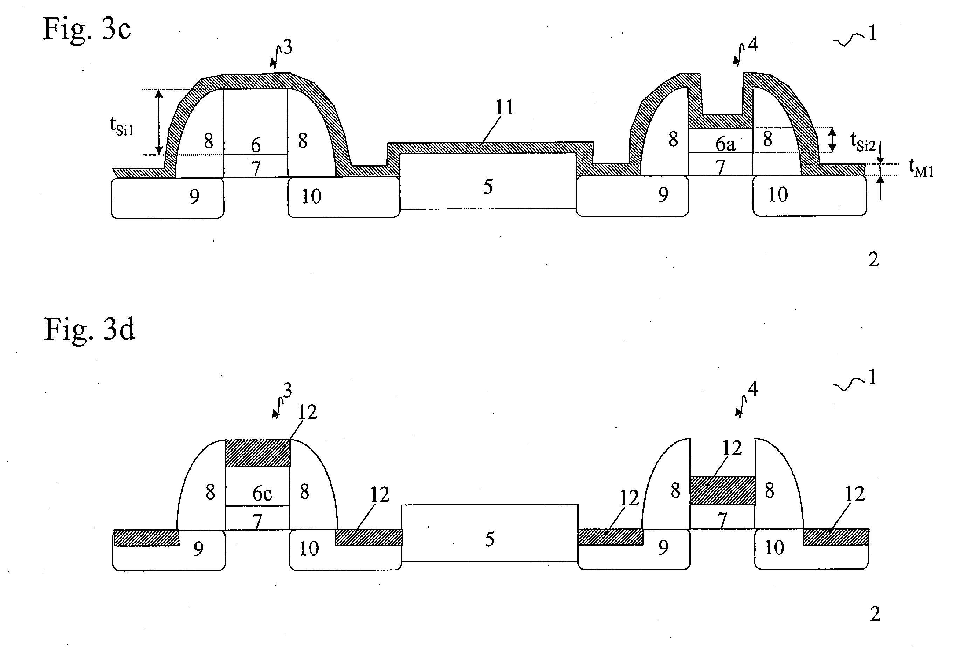

In the next process step illustrated in Figure 3c, a layer of metal (11) having thickness t_{M} is uniformly deposited over the substrate. For the pMOS transistor (4) the thickness t_{M} and t_{Si2} are chosen such that the thickness ratio t_{M}/t_{Si2} is obtained corresponding with the desired silicide phase to be formed throughout the semiconductor layer (6a). For the nMOS device, the thickness t_{M} and t_{Si1} are chosen such that complete silicidation of the semiconductor layer (6) is avoided.

The CMOS device (11) is heated in a first thermal process step (e.g., Rapid Thermal Processing (RTP)), to form a metal-rich fully silicide gate electrode (12) for the pMOS transistor (4) and a metal-rich partially silicided gate electrode (12) for the nMOS transistor (3).

Unreacted metal (11) is removed yielding the CMOS device (1) shown in Figure 3d.

The silicidation process according to the present invention is completed by a second thermal process step (e.g., Rapid Thermal Processing (RTP)), in which the partially silicided nMOS (3) gate electrode (12) becomes fully silicided.

During the first thermal step of this two-steps silicidation process, a metal-rich silicide is formed on all transistors such that for transistors with a thinner semiconductor gate electrode this gate electrode becomes fully silicided, while the gate electrode of transistors with a thicker semiconductor gate electrode is only partially silicided. Such partial silicided gate electrode, hence, contains two portions: a silicided metal-rich portion adjacent the metal layer and an unsilicided semiconductor portion adjacent the gate dielectric.

The thermal budget of the first silicidation step is selected to control the amount of silicide formed in the partially silicided gate electrode. Sufficient thermal energy is provided to silicide only a portion of the semiconductor gate electrode but with sufficient metal incorporated therein.

Temperature and time parameters of said first thermal step can be determined for each silicide phase by establishing a silicidation kinetics graph, such as the Ni₂Si silicidation kinetics graph drawn up and represented in figure 5.

During the second thermal step, the partially silicided gate electrode becomes fully silicided whereby metal from silicided metal-rich portion reacts with semiconductor material of the unsilicided portion to yield the selected silicide phase for the fully silicided gate electrode.

A semiconductor process flow, corresponding to a two-steps silicidation process of the invention, has the advantage that the amount of silicide formed does not depend on the amount of metal available, but on the thermal budget of the first thermal step. Hence the thickness of the metal layer deposited is less critical thereby increasing the process window. Any excess metal is removed by a selective wet etch after the first thermal process step such that during the second thermal step only metal incorporated in the metal-rich silicided portion of the gate electrode will react.

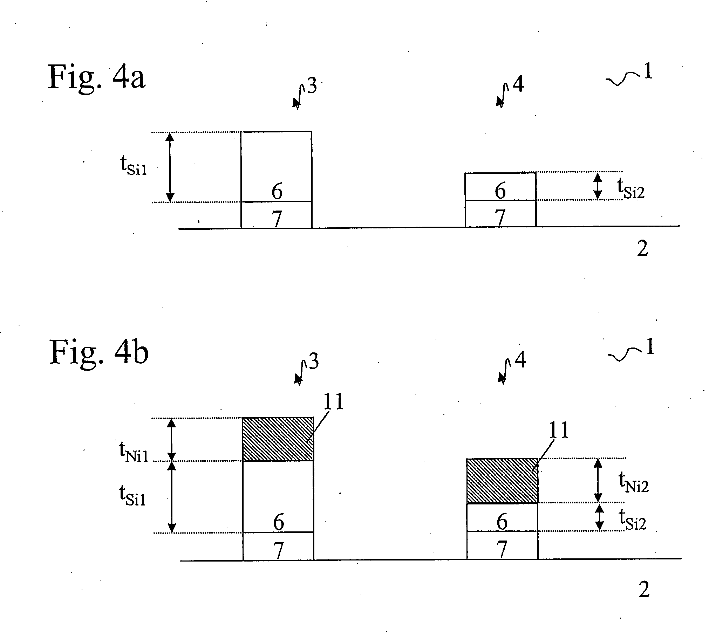

The above embodiment is illustrated by Figures 4a-d where transistor (3) is now a nMOS transistor for which a NiSi gate electrode (12) is to be formed and transistor (4) is now a pMOS transistor for which a metal-rich nickel silicide (e.g., Ni₂Si) gate electrode (12) is to be formed. As shown in Figure 4a, a nMOS transistor (3) and pMOS transistor (4) are formed whereby the semiconductor gate electrode (6) is thicker for the nMOS transistor then for the pMOS transistor: t_{Si1} > t_{Si2}.

As shown in Figure 4b, a nickel layer (11) is deposited over the gate electrodes (6) and, in this embodiment, this nickel layer (11) has the same thickness for both types of transistors (3, 4): t_{M1} = t_{M2}. The thickness of the unreacted metal layer (11) and of the unreacted semiconductor gate electrode is selected such that a NiSi phase is formed for the fully silicided gate nMOS transistor and a Ni₂Si for the fully silicided gate pMOS transistor:
- t_{Ni1}/t_{Si1} > 0.54, preferably at about 0.6 (nMOS);
- t_{Ni2}/t_{Si2} > 1.1, preferably at about 1.2 (pMOS).

These requirements can also be expressed in ratio of atomic percentage of the as-deposited layers as the aim of the first thermal step is to introduce sufficient nickel in the semiconductor gate such that for both types of transistors a nickel-rich silicide is formed. For the pMOS transistor this metal-rich silicide extends over the whole of the gate electrode, while for the nMOS transistor only a portion of the gate electrode is silicided while an uniform layer of silicon (6c) remains in the nMOS gate electrode near the gate dielectric (7):
- Ni/Si (at%) > 1 (nMOS);
- Ni/Si (at%) > 2 (pMOS).

These above relationships, either expressed in thickness or atomic percentage ratio, only define a lower limit for the amount of nickel present. Sufficient nickel must be present to form a nickel-rich silicide and any nickel in excess will be removed during the subsequent selective etch.

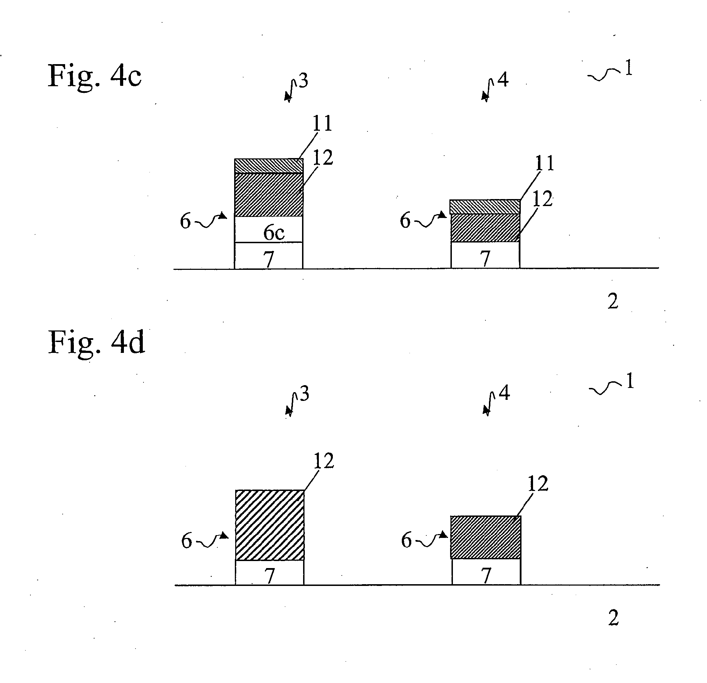

As shown in Figure 4c, a first thermal process step is performed. The thermal budget of this first thermal step is selected to fully silicide the gate electrode of the pMOS transistor (4), e.g. such that the nickel-to-silicon ratio of the all nickel (12) and silicon after this first thermal step and after the selective etch, meets the relationship: Ni/Si (at%)>2.

All semiconductor material of the pMOS gate electrode is reacted with the nickel and a metal-rich silicide (12) is formed.

This thermal budget of this first thermal step is selected to only partially silicide the gate electrode of the nMOS transistor: only a portion of the semiconductor material of the nMOS gate electrode will react with the nickel. This metal-rich portion will provide during the second thermal process step the nickel to react with the unsilicided portion such that an overall nickel-poor full silicided gate electrode is formed on the nMOS transistor.

Any nickel in excess (11) will be removed during the subsequent selective etch. The thermal budget of this first thermal step is selected such that the nickel-to-silicon ratio of the all nickel (12) and silicon, be it in the silicided portion (12) and in the unsilicided portion (6c), still present in the gate electrode of the nMOS transistor, after this first thermal step and after the selective etch, meets the relationship: 1<Ni/Si (at%)<2 (nMOS), preferably 1<Ni/Si (at%)<1.5, more preferably Ni/Si (at%) is about 1.2.

For a given thickness of polysilicon t_{Si1}, the ratio of the reacted nickel and silicon can be determined from the silicidation kinetics and the time-temperature dependence of the first thermal process step. Figure 5 shows the Ni₂Si silicidation kinetics. The Ni₂Si thickness as function of time for various temperatures is given for undoped (open symbols), As-doped (+, -) or B-doped (solid symbols). The activation energy Ea of this physical process is found to be around 1.5eV.

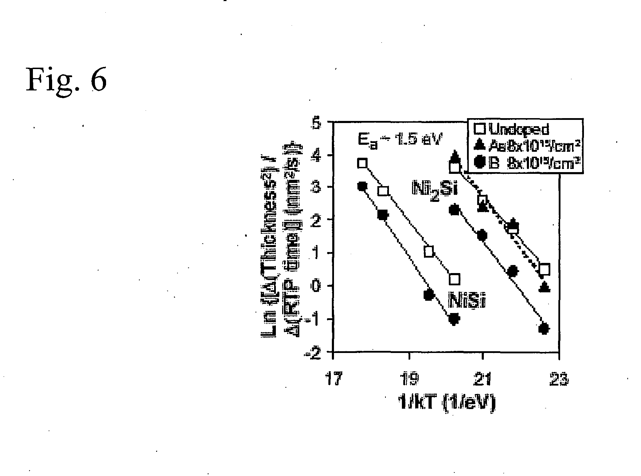

Figure 6 shows the logarithm of the silicide growth rates for NiSi and Ni₂Si as function of temperature T for undoped (open squares), As-doped (solid triangles), and B-doped (solid circles) silicides. At low temperatures, i.e. at temperatures as low as (about) 240°C, a Ni₂Si phase will start to be formed in a process that is controlled by the diffusion of the nickel from the nickel layer (11) into the polysilicon gate electrode (6). If excess nickel is removed and only nickel from the nickel-rich silicided portion (12) is available, then NiSi will be grown at higher temperatures, e.g. at a temperature comprised between (about) 350°C and (about) 700°C, in a process that is controlled by the diffusion of nickel from the metal-rich portion (12) into the unsilicided portion (6c) resulting in a fully silicided NiSi gate electrode for the nMOS transistor (3). For a given thickness of polysilicon t_{Si1}, the process window for the first thermal process step can be determined using the information of Figures 5 and 6.

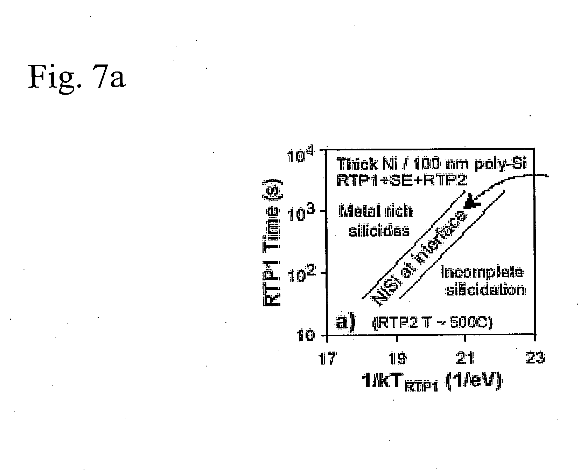

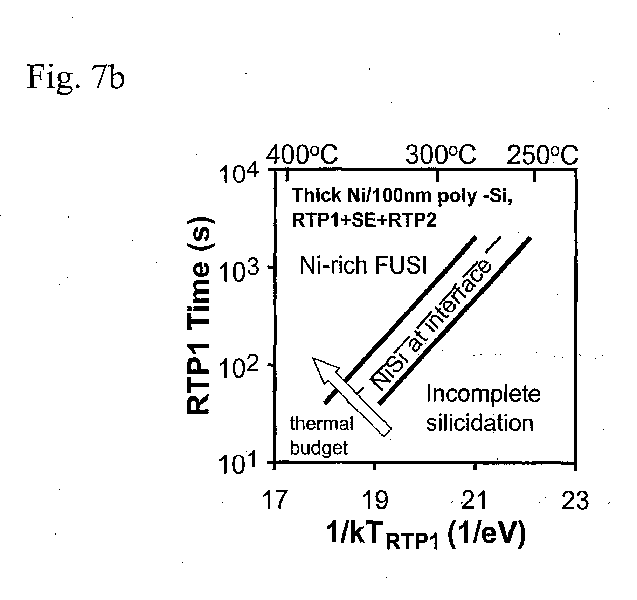

Figure 7 shows the process window of this first thermal step (dotted area). Any combination of time and temperature within this process window will result in a nickel-silicon atomic percentage ratio corresponding to a partial nickel-rich silicidation of the nMOS gate electrode after the first thermal process step and a complete silicidation of this gate electrode after the second thermal process step. The thickness of the partial silicided nMOS gate electrode is about the thickness of the fully silicided pMOS gate electrode if the same metal-rich silicide phase is formed for both types of transistors during the first thermal step.

As shown in Figure 4d, the partially silicided nMOS gate electrode is fully silicided whereby nickel from the silicided nickel-rich portion reacts with silicon from the unsilicided portion. Due to this redistribution of the nickel, the selected nickel-to-silicon ratio, in this case NiSi, is obtained uniformly over the nMOS gate electrode (6). As no excess nickel is present, i.e. only nickel that has really been reacted, the nickel-to-silicon ratio of the pMOS gate electrode is substantially maintained and further growth of the nickel-rich portion of the partial silicided nMOS gate electrode is prevented. The thermal budget of the second thermal step is chosen such that for the nMOS device all nickel from the nickel-rich portion (12) reacts with all silicon from the gate electrode (12, 6c).

For each silicidation metal (11) and silicide phase to be formed curves similar to Figures 5, 6 and 7 can be generated. From such curves, the growth rate of the metal-rich silicide and the process window for the thermal budget of the first thermal process step can be determined. Relationships 4-7 can be generalized as follows. If fully silicided gate electrodes with a metal-low Mₓ₃Si_{y3} (3) and a metal-rich Mₓ₂Si_{y2} (4) silicide are to be formed, the following relationships are valid:
- as-deposited:
   - metal/silicon (at % ratio) > x₃/y₃ (nMOS);
   - metal/silicon (at % ratio) > x₂/y₂ (pMOS);
- after the first thermal step and selective removal of excess metal:
   - x₃/y₃ < metal/silicon (at % ratio) < x'₃/y'₃ (nMOS); with x'₃/y'₃ being the atomic percentage ratio of the next metal-silicon compound which is more metal rich than the compound which is to be formed, at least at the interface, e.g. NiSi: x₃/y₃ = 1, Ni₂Si: x'₃/y'₃ = 2.

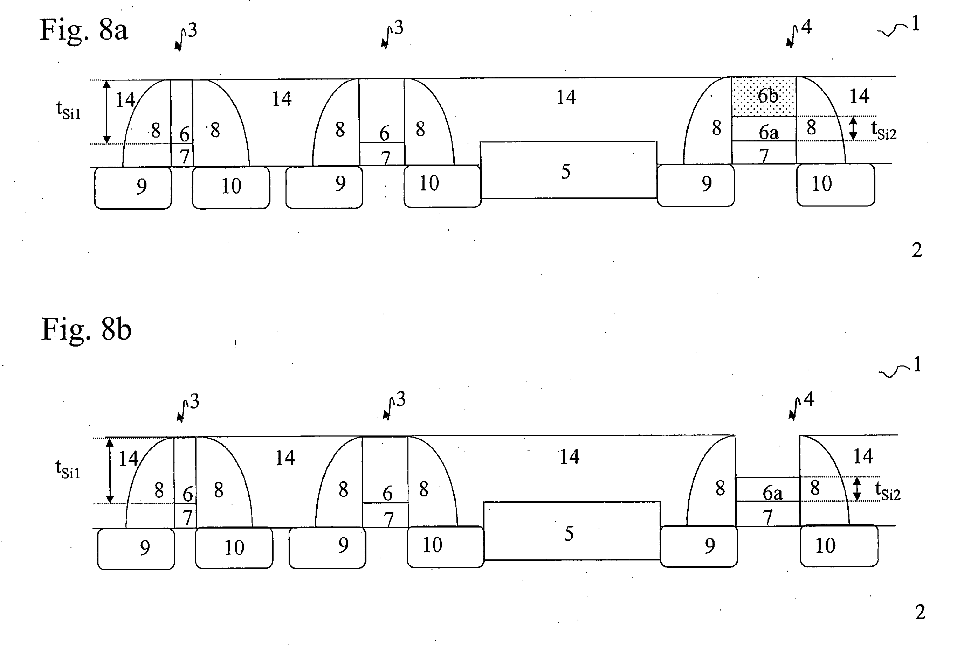

In the example illustrated in Figures 8a-e, the junction regions (9, 10) are silicided together with the gate electrodes (6). Figures 8a-e schematically illustrate a process flow that allows the gate electrodes (6) to be silicided independently from the source/drain junction regions (9, 10).

Figure 8a shows a CMOS device (1) according to this example. In addition to the device shown in Figure 8a, a dielectric (14) is deposited over the substrate and planarized using Chemical-Mechanical-Polishing (CMP) yielding the CMOS device (1) of Figure 3a. Two nMOS transistors (3) are shown only differing in the length of the gate, i.e. the distance between source (9) and drain (10) region. All transistors (3, 4) were formed with polysilicon as gate electrode material (6) having a thickness t_{Si1} = 100 nm and HfSiON as gate dielectric (7).

The reduced height (t_{Si2}) of the polysilicon gate electrode (6) for the pMOS device (4) was achieved by etch back of the pMOS gates just before gate silicidation as shown in Figure 8b.

Optionally, one can use an additional masking step to expose the gate electrode of selected transistors such that only for selected pMOS transistors the thickness of the polysilicon gate electrode is reduced such that during the two-steps silicidation process a metal-rich silicide is formed while for other pMOS transistors the original polysilicon thickness is maintained such that a metal-poor silicide is obtained during the same two-steps silicidation process.

The polysilicon thickness of the gate electrode of the pMOS transistor was reduced to 30% or 45% (tₛ₂) of the original polysilicon thickness (t_{S1}).

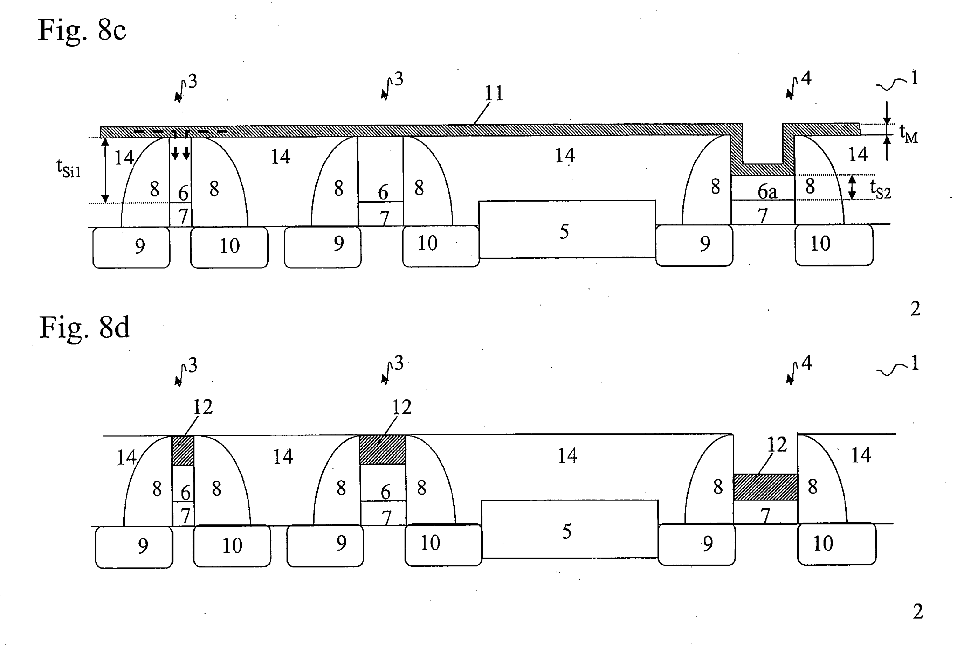

A single Ni film (11), shown in Figure 8c, having a thickness t_{M} = 60 nm, was used to obtain a Ni/Si thickness ratio of t_{M}/t_{Si1} = 0.6 for the nMOS transistors (3) and t_{M}/t_{Si2} = 2 (30% reduction) or 1.3 (45% reduction) for the pMOS transistor (4). Simultaneous silicidation of nMOS and pMOS transistors was done in a 2 step Ni FUSI process.

Figure 8d shows the CMOS device (1) after the first thermal step, performed at 340°C for 30s, with a metal-rich (12) FUSI gate electrode (6) for the pMOS transistor (4) and a partially silicided (12/6c) gate electrode (6) for both nMOS transistors (3) independent of their gate length.

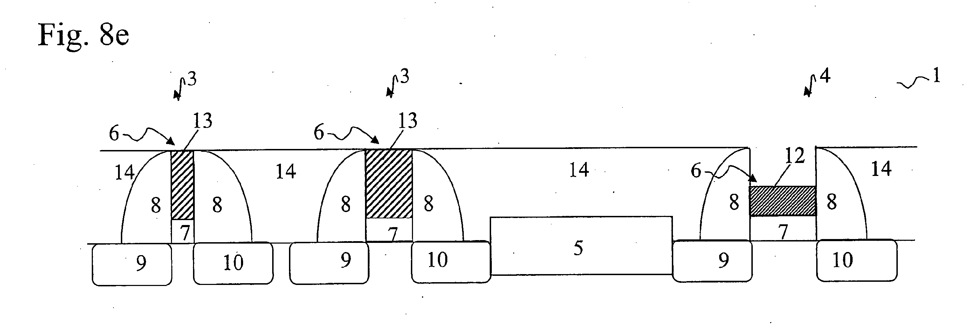

Figure 8e shows the CMOS device (1) after the second thermal step, performed at 520°C for 30 sec., with a FUSI gate electrode (6) for all transistors (3, 4).

From XRD analysis, the phase present in the gate electrode of the pMOS transistors (4) was identified as Ni₂Si, while a stack of Ni₂Si / NiSi was identified for the gate electrode of the nMOS transistors. The absence of more Ni-rich phases (e.g., Ni₃Si₂, Ni₂Si, Ni₃₁Si₁₂, and Ni₃Si) in the FUSI gate electrode of the pMOS transistor is to be attributed to the low thermal budget of the first thermal step and shows that the silicidation process of this first thermal step was controlled by the predetermined thermal budget.

The sheet resistance Rs of the FUSI gate electrode is found to be about 2 Ohm/sq for the nMOS transistors, independent of the gate length, and about 10 Ohm/sq (45% height reduction) or about 16 Ohm/sq (30% height reduction) for the pMOS transistors. The sheet resistance values are consistent with the presence of mainly NiSi phase in the nMOS transistor and Ni₂Si phase in the pMOS transistor.

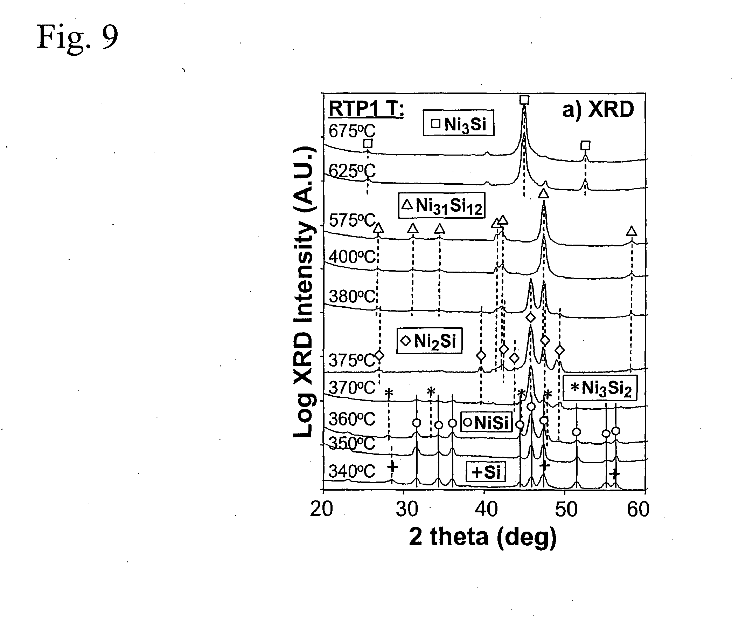

Figure 9 shows the crystallographic characterization of silicide films manufactured using a manufacturing process as illustrated by figures 2a-d.

The silicide films are characterized using X-ray Diffraction (XRD).

These fully silicided gates are obtained by depositing 170nm of nickel on 100 nm polycrystalline silicon, such that the silicidation reaction is not limited by the supply of the refractory metal, in this example nickel.

The gate dielectric is a hafnium-silicon-oxide-nitride dielectric. The two-step thermal process is performed using an ASM Levitor RTP system.

The temperature of the first thermal step (RTP1) is varied from about 340°C to about 675°C. The time of this first thermal step was set at about 30s.

A selected etch is performed to remove unreacted nickel after the first thermal step.

Thereafter a second thermal step (RTP2) is executed at 480°C for about 30s.

It is found that when the reaction is not limited by the availability of nickel, the resulting silicide phase of a fully silicided polysilicon gate can be effectively controlled by the thermal budget of the first thermal step (RTP1).

Within the conditions set for figure 9 in terms of thicknesses (170nm Ni / 100nm poly-Si) and time (30 seconds), for RTP1 temperatures less than or equal to 350°C, the polysilicon gates are not fully silicided (even if abundant nickel is present).

Poly-Si (+Si) X-ray Diffraction (XRD) peaks are observed as shown in figure 9. From 350°C onwards complete silicidation of the 100nm polysilicon gate can occur.

For RTP1 temperatures in the range of 355°C to 375°C, XRD shows the presence of various nickel silicide phases in the fully silicided gate.

Figure 9 illustrates the nickel silicide phases present in the fully silicided gate electrode for first thermal temperatures of respectively 360°C, 370°C and 375°C: NiSi (open circles), Ni₃Si₂ (stars) and Ni₂Si (open diamonds) phases are formed.

Rutherford Backscattering Spectrometry (RBS) and Transmission Electron Microscopy (TEM) analysis showed that the thus-obtained fully silicided films have a layered structure with the metal-poor phase, in this case NiSi, at the bottom of the fully silicided gate electrode (7) in contact with the underlying gate dielectric (6) (i.e. at the interface), while the metal-rich silicides, in this case Ni₃Si₂ and Ni₂Si, are in the upper part of the fully silicided gate electrode.

The work function of these gate electrodes will thus be determined by the NiSi phase at the interface.

Within the conditions set for figure 9, the RTP1 temperature process window for forming NiSi, at least at the interface, is about 20°C or less.

Within the conditions set for figure 9, the process window of the first thermal step (RTP1) for forming Ni₂Si at least adjacent the gate dielectric (7) (i.e. at least at the interface) is 25°C or less.

If the temperature of the first thermal step (RTP1) is above 400°C, Ni₃₁Si₁₂ will start to grow. In the temperature range from about 400°C to about 600°C a fully silicided gate electrode will be formed during the first thermal step where essentially only a Ni₃₁Si₁₂ phase can be detected. Figure 9 shows fully silicided gate electrodes formed respectively at RTP1 temperatures of 400°C and 575°C only exhibiting Ni₃₁Si₁₂ XRD peaks (open triangle).

If the temperature of the first thermal step (RTP1) is above 625°C, Ni₃Si will start to grow. In a temperature range above about 625°C a fully silicided gate electrode will be formed during the first thermal step where essentially only a Ni₃Si phase can be detected. Figure 9 shows fully silicided gate electrodes formed respectively at RTP1 temperatures of 625°C and 675°C only exhibiting Ni₃Si XRD peaks (open squares). The RTP1 temperature process window to form Ni₃₁Si₁₂, at least at the interface, is about 200°C.

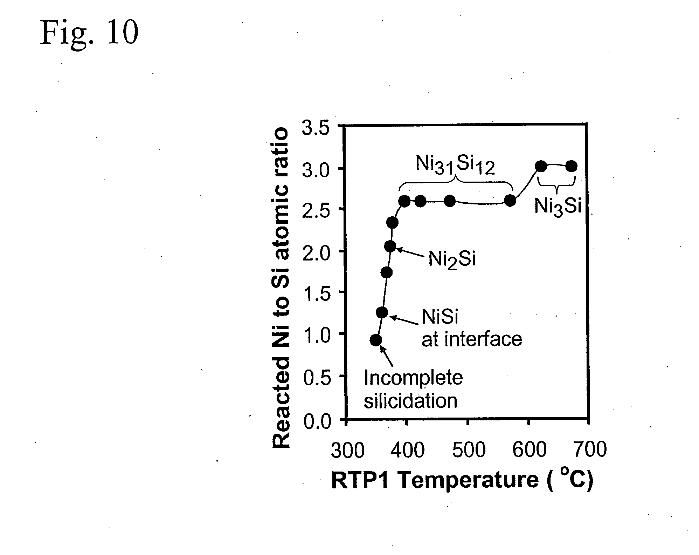

The method of controlling the phase formation for a fully silicided gate electrode is illustrated by figure 10 using the experimental results in relation with Fig. 9 for the example of nickel silicide.

The Ni to Si reacted ratio is controlled by the thermal budget of the first RTP step (RTP1) which thermal budget is determined by its time and temperature. In figure 10, the time is kept constant at 30s, while the temperature of the first thermal step is varied to vary the thermal budget thereof.

At low RTP1 thermal budgets, i.e. below 350°C, insufficient Ni has reacted, at least for transistors having a large gate lengths, e.g. 100nm or above, and the polycrystalline silicon gate electrode remains incompletely silicided even after performing a second thermal step RTP2.

In the thermal budget range associated with the RP1 temperature range 350°C to 375°C sufficient Ni has reacted to result in a full silicidation of the gate electrode after RTP2 with NiSi in contact with the gate dielectric (7) (i.e. at the interface) for gate lengths above and below 100nm.

In the thermal budget range associated with the RP1 temperature range 375°C to 400°C sufficient Ni has reacted to result in a full silicidation of the gate electrode after RTP2 with Ni₂Si in contact with the gate dielectric (7) (i.e. at the interface) for gate lengths above and below 100nm.

In the thermal budget range associated with the RP1 temperature range 400°C to 600°C sufficient Ni has reacted to result in a full silicidation of the gate electrode after RTP2 with Ni₃₁Si₁₂ in contact with the gate dielectric (7) (i.e. at the interface) for gate lengths above and below 100nm.

In the thermal budget range associated with the RP1 temperature range above 600°C sufficient Ni has reacted to result in a full silicidation of the gate electrode after RTP2 with Ni₃Si₁ in contact with the gate dielectric (7) (i.e. at the interface) for gate lengths above and below 100nm.

In a particularly preferred embodiment, a CMOS device is provided comprising a NiSi FUSI gate electrode on nMOS and a Ni₂Si or a Ni₃₁Si₁₂ FUSI gate electrode on pMOS.

Ni FUSI gate CMOS circuits with HfSiON gate dielectric (1.5 nm equivalent oxide thickness, (Hf/ (Hf+Si)=50 at %) can be fabricated using a CMP flow as described for example by K. G. Anil et al., "Demonstration of fully Ni-silicided metal gates on HfO2 based high-k gate dielectrics as a candidate for low power applications," in Symp. VLSI Tech. Dig., 2004, pp. 190-191.

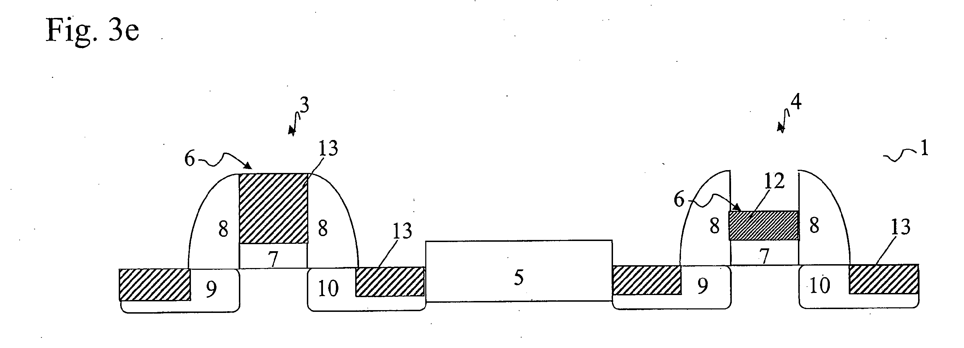

The CMOS integration flow (for example Fig. 3 or Fig. 8) comprises a poly-Si etch back step to reduce the height of pMOS devices before gate silicidation, and a 2-step RTP gate silicidation process performed simultaneously on nMOS and pMOS devices.

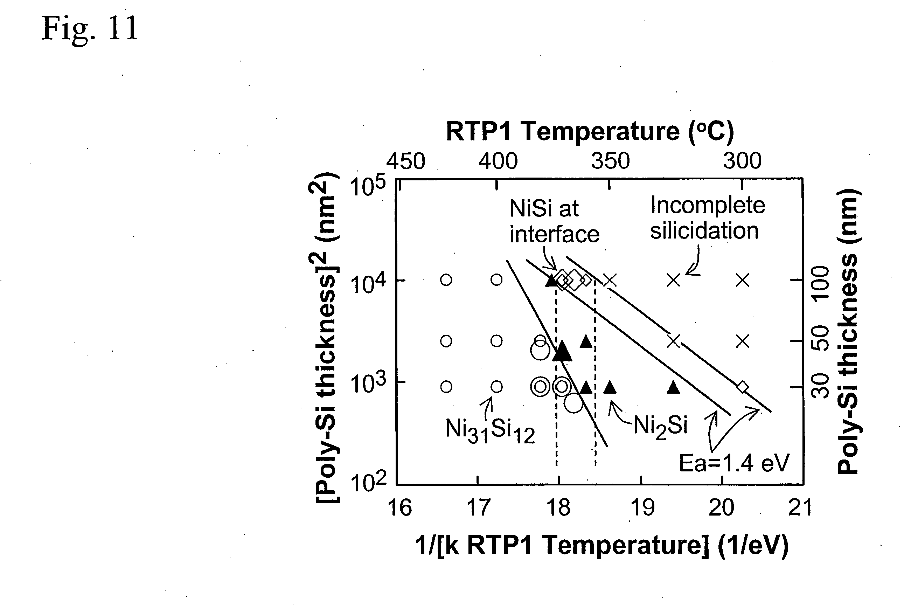

Poly-Si thickness can be 100 nm as deposited, and reduced on pMOS devices by poly-Si etch back to thicknesses in the 25 to 50 nm range. In particular, the poly-Si thickness can be reduced to about 50 nm for obtaining a Ni₂Si FUSI gate electrode on pMOS, and to 25 to 30 nm for obtaining a Ni₃₁Si₁₂ FUSI gate electrode on pMOS (see Fig. 11).

Figure 11 illustrates that with increasing polythickness, even if sufficient nickel is available for silicidation, the temperature of the first anneal step (RTP1) at which a selected phase is to be formed will shift to higher values if the time period of this first anneal step is kept fixed. If the temperature and time of the first anneal step is kept constant, i.e. a constant thermal budget, then incomplete silicidation is likely to occur with increasing thickness of the polysilicon layer.

Wafers can also be fabricated with deposited poly-Si thicknesses of 30 and 50 nm, for physical characterization.

Ni thickness for gate silicidation can be in the 60-170 nm range.

RTP silicidation steps can be performed in an ASM Levitor RTP system. The RTP1 temperatures can be comprised between about 300° and about 675°C for about 30s. A selective Ni etch is then performed before the second RTP step, with RTP2 temperature of about 480°C, for about 30s.

X-ray diffraction (XRD) can be used for phase identification.

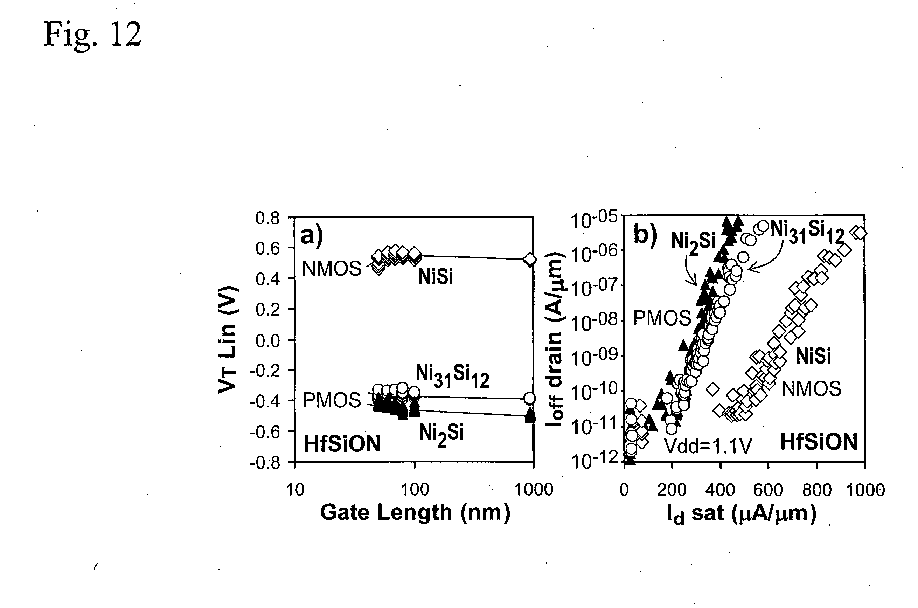

The Vₜ roll-off and Iₒₙ-I_{off} characteristics are shown in Fig. 12. Smooth Vt roll-off is observed for NiSi gate nMOS devices and for both Ni₂Si and Ni₃₁Si₁₂ gate pMOS devices, with ~90 mV lower |Vt| for Ni₃₁Si₁₂ compared to Ni₂Si (Fig. 12a), in agreement with the measured difference in WF values. Improved performance is also observed for Ni₃₁Si₁₂ compared to Ni₂Si (Fig. 12b).

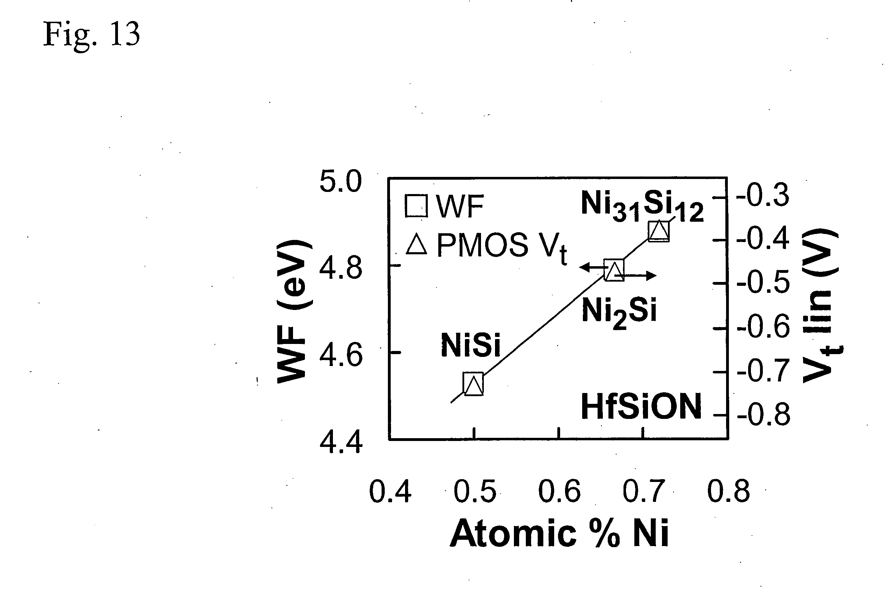

Working ring oscillators can be fabricated with NiSi nMOS gates and Ni₃₁Si₁₂ pMOS gates achieving improved performance as well. A total reduction in pMOS Vₜ of 350 mV is achieved by implementing the dual WF CMOS flow with Ni₃₁Si₁₂ FUSI in pMOS, when compared to a single WF flow with NiSi on nMOS and pMOS (Fig. 13).

In other words, an improvement in threshold voltage of 90 mV and improved device performance is obtained for Ni₃₁Si₁₂ compared to Ni₂Si FUSI gates. And a pMOS Vt reduction of 350 mV is obtained for Ni₃₁Si₁₂ compared to NiSi FUSI gates.

## Claims

1. A method of manufacturing a dual fully-silicided-gate device, comprising the steps of:
- providing a first MOSFET (3) having a first semiconductor gate electrode with a thickness t_{Si1};
- providing a second MOSFET (4) having a second semiconductor gate electrode with a thickness t_{Si2}, wherein t_{Si2} < t_{Si1};
- depositing a first metal layer (11) having a thickness t_{M1} on the first semiconductor gate electrode of the first MOSFET;
- depositing a second metal layer having a thickness t_{M2} on the second semiconductor gate electrode of the second MOSFET;
- performing a first thermal process step to partially silicide the first semiconductor gate of the first MOSFET to form a silicide Mₓ₁S_{y1} and to fully silicide the second semiconductor gate of the second MOSFET to form a silicide Mx₂S_{y2};
- selectively removing the unreacted fraction of the deposited metal; and
- performing a second thermal process step to fully silicide the partially silicided first semiconductor gate electrode to form a silicide Mₓ₃S_{y3}.

2. The method of claim 1, wherein x₂/y₂ > x₃/y₃

3. The method of claim 1 or 2, wherein performing the first thermal process step comprises selecting a thermal budget to partially silicided the first gate electrode of the first MOSFET and to fully silicide the second gate electrode of the second MOSFET.

4. The method of any of claims 1 to 3, wherein the first and second metal layers have the same composition and thickness (t_{M2} ≈ t_{M1}), and wherein during the first thermal process step the same silicide is formed for the first and second MOSFETs (x₁/y₁ ≈ x₂/y₂).

5. The method according to any of claims 1 to 4, wherein the first and second semiconductor gate electrodes of the first and second MOSFETs comprise or consist of silicon.

6. The method according to claim 5, wherein the thickness ratios t_{M1}/t_{Si1} and t_{M2}/t_{Si2} are selected such that the atomic percentage ratio metal-to-semiconductor is greater than one for the first MOSFET and greater than two for the second MOSFET.

7. The method according to claim 6, wherein the atomic percentage ratio metal-to-semiconductor of the partially silicided first gate electrode of the first MOSFET is greater than one and less than two.

8. The method according to any of claims 5 to 7, wherein said first and said second metal layer comprise or consist of nickel.

9. The method according to claim 8, wherein x₁/y₁ is equal to x₂/y₂ and higher than 1 (i.e, x₁/y₁ ≈ x₂/y₂ >1).

10. The method according to claim 9, wherein x₂/y₂ is higher than 2 and less or equal to 3 and wherein x_{3/}y₃) is equal to 1 (i.e. 2 < x₂/y₂ ≤ 3 and x₃/y₃ ≈ 1) .

11. The method according to claim 1, wherein said first metal layer and said second metal layer are a same metal layer, with a constant thickness, deposited over each of said semiconductor gate electrode, wherein the silicide formed has a ratio metal-to-semiconductor larger than 1, and whereby said first and second MOSFET have a different work function.

12. The method of claim 11, wherein the dual fully-silicided-gate device is a CMOS device, and the MOSFET with the thicker semiconductor gate electrode is an nMOSFET and the MOSFET with the thinner semiconductor gate electrode is a pMOSFET.

13. The method of claim 11 or 12, wherein the metal-to-semiconductor atomic percentage ratio of the fully silicided gate electrode formed after said second thermal step is lower, at least at the bottom of the gate dielectric, than the metal-to-semiconductor atomic percentage ratio of the partially silicided gate electrode formed after said first thermal step.

14. The method according to any of claims 11 to 13, wherein said semiconductor gate electrodes comprise or consist of silicon.

15. The method according to any of claims 11 to 14, wherein said metal layer comprises or consists of nickel.

16. The method according to claim 15, wherein said silicide obtained after said first thermal step is a NiₓSi_{y} silicide, wherein x and y are integers, with 2 ≤ x/y ≤ 3.

17. The method according to any of claims 11 to 16, wherein said first and second thermal steps are Rapid Thermal Processing, respectively RTP1 and RTP2, steps.

18. The method according to claim 17, wherein the thickness of said pMOS gate electrode is less than 100 nm, preferably comprised between 20 nm and 75 nm , more preferably comprised between 25 nm and 50 nm.

19. The method according to claim 17 or 18, wherein the thickness of said nMOS gate electrode is 100 nm, preferably comprised between 50 nm and 100 nm , more preferably comprised between 50 nm and 75 nm.

20. The method according to claim 19, wherein the RTP1 temperatures are between 250° and 675°C, preferably between 350° and 675°C, for 15 to 60 seconds.

21. The method according to claim 19 or 20, wherein the RTP2 temperatures are between 350° and 700°C for 15 to 60 seconds.

22. The method according to claim 19, wherein the RTP1 temperatures are between 350° and 675°C for 30 seconds and the RTP2 temperature is 480°C for 30 seconds.

## Patentansprüche

1. Verfahren zur Herstellung einer dualen komplett silizidierten Gatevorrichtung, welches folgende Schritte umfasst:
- das Bereitstellen eines ersten MOSFET (3) mit einer ersten Halbleiter-Gateelektrode mit einer Dicke von t_{Si1};
- das Bereitstellen eines zweiten MOSFET (4) mit einer zweiten Halbleiter-Gateelektrode mit einer Dicke von t_{Si2}, wobei t_{Si2} < t_{Si1};
- das Aufbringen einer ersten Metallschicht (11) mit einer Dicke von t_{M1} auf der ersten Halbleiter-Gateelektrode des ersten MOSFET;
- das Aufbringen einer zweiten Metallschicht mit einer Dicke von t_{M2} auf der zweiten Halbleiter-Gateelektrode des zweiten MOSFET;
- das Durchführen eines ersten thermischen Prozessschrittes zum teilweisen Silizidieren des ersten Halbleiter-Gates des ersten MOSFET zur Bildung eines Silizids Mₓ₁S_{y1} und zum kompletten Silizidieren des zweiten Halbleiter-Gates des zweiten MOSFET zur Bildung eines Silizids Mₓ₂S_{y2};
- das selektive Entfernen der nichtreagierten Fraktion des aufgebrachten Metalls; und
- das Durchführen eines zweiten thermischen Prozessschrittes zum kompletten Silizidieren der teilweise silizidierten ersten Halbleiter-Gateelektrode zur Bildung eines Silizids Mₓ₃S_{y3}.

2. Verfahren nach Anspruch 1, wobei x₂/y₂ > x₃/y₃.

3. Verfahren nach Anspruch 1 oder 2, wobei das Durchführen des ersten thermischen Prozessschrittes das Auswählen eines thermischen Budgets zum teilweisen Silizidieren der ersten Gateelektrode des ersten MOSFET und zum kompletten Silizidieren der zweiten Gateelektrode des zweiten MOSFET umfasst.

4. Verfahren nach einem der Ansprüche 1 bis 3, wobei die erste und zweite Metallschicht die gleiche Zusammensetzung und Dicke (t_{M2} ≈ t_{M1}) aufweisen, und wobei während des ersten thermischen Prozessschrittes das gleiche Silizid für den ersten und zweiten MOSFET gebildet wird (x₁/_{y1} ≈ x₂/y₂).

5. Verfahren nach einem der Ansprüche 1 bis 4, wobei die erste und zweite Halbleiter-Gateelektrode des ersten und zweiten MOSFET Silizium umfassen oder daraus bestehen.

6. Verfahren nach Anspruch 5, wobei die Dickenverhältnisse t_{M1}/t_{Si1} und t_{M2}/t_{Si2} so ausgewählt sind, dass das Atomprozentverhältnis Metall-zu-Halbleiter für den ersten MOSFET größer ist als eins und für den zweiten MOSFET größer als zwei.

7. Verfahren nach Anspruch 6, wobei das Atomprozentverhältnis Metall-zu-Halbleiter der teilweise silizidierten ersten Gateelektrode des ersten MOSFET größer ist als eins und niedriger als zwei.

8. Verfahren nach einem der Ansprüche 5 bis 7, wobei die erste und die zweite Metallschicht Nickel umfassen oder daraus bestehen.

9. Verfahren nach Anspruch 8, wobei x₁/y₁ gleich x₂/_{y2} und größer als 1 ist (d.h. x₁/y₁ ≈ x₂/y₂ > 1) .

10. Verfahren nach Anspruch 9, wobei x₂/y₂ größer als 2 und niedriger als oder gleich 3 ist, und wobei x₃/y₃ gleich 1 ist (d.h. 2 < x₂/y₂ ≤ 3 und x₃/y₃ ≈ 1).

11. Verfahren nach Anspruch 1, wobei die erste Metallschicht und die zweite Metallschicht eine gleiche Metallschicht sind, mit einer konstanten Dicke, aufgebracht auf jeder der Halbleiter-Gateelektroden, wobei das gebildete Silizid ein Verhältnis Metall-zu-Halbleiter größer als 1 aufweist, und wodurch der erste und zweite MOSFET eine unterschiedliche Arbeitsfunktion aufweisen.

12. Verfahren nach Anspruch 11, wobei die duale komplett silizidierte Gatevorrichtung eine CMOS-Vorrichtung ist, und der MOSFET mit der dickeren Halbleiter-Gateelektrode ein nMOSFET ist und der MOSFET mit der dünneren Halbleiter-Gateelektrode ein pMOSFET ist.

13. Verfahren nach Anspruch 11 oder 12, wobei das Metall-zu-Halbleiter Atomprozentverhältnis der komplett silizidierten Gateelektrode gebildet nach dem zweiten thermischen Schritt geringer ist, zumindest an der Unterseite des Gate-Dielektrikums, als das Metall-zu-Halbleiter Atomprozentverhältnis der teilweise silizidierten Gateelektrode gebildet nach dem ersten thermischen Schritt.

14. Verfahren nach einem der Ansprüche 11 bis 13, wobei die Halbleiter-Gateelektroden Silizium umfassen oder daraus bestehen.

15. Verfahren nach einem der Ansprüche 11 bis 14, wobei die Metallschicht Nickel umfasst oder daraus besteht.

16. Verfahren nach Anspruch 15, wobei das Silizid welches nach dem besagten ersten thermischen Schritt erhalten wird ein NiₓSi_{y}-Silizid ist, wobei x und y ganze Zahlen sind, mit 2 ≤ x/y ≤ 3.

17. Verfahren nach einem der Ansprüche 11 bis 16, wobei der erste und zweite thermische Schritt schnelle thermische Verfahrensschritte, jeweils RTP1 und RTP2, sind.

18. Verfahren nach Anspruch 17, wobei die Dicke der besagten pMOS-Gateelektrode geringer ist als 100 nm, vorzugsweise zwischen 20 nm und 75 nm, bevorzugter zwischen 25 nm und 50 nm.

19. Verfahren nach Anspruch 17 oder 18, wobei die Dicke der besagten nMOS-Gateelektrode 100 nm ist, vorzugsweise zwischen 50 nm und 100 nm, bevorzugter zwischen 50 nm und 75 nm.

20. Verfahren nach Anspruch 19, wobei die RTP1-Temperaturen für 15 bis 60 Sekunden zwischen 250 °C und 675 °C liegen, vorzugsweise zwischen 350 °C und 675 °C.

21. Verfahren nach Anspruch 19 oder 20, wobei die RTP2-Temperaturen für 15 bis 60 Sekunden zwischen 350 °C und 700 °C liegen.

22. Verfahren nach Anspruch 19, wobei die RTP1-Temperaturen für 30 Sekunden zwischen 350 °C und 675 °C liegen und die RTP2-Temperatur für 30 Sekunden 480 °C ist.

## Revendications

1. Procédé de fabrication d'un dispositif à grille double complètement siliciurée, comprenant les étapes consistant à :
- prévoir un premier MOSFET (3) ayant une première électrode de grille semi-conductrice ayant une épaisseur t_{Si1} ;
- prévoir un second MOSFET (4) ayant une seconde électrode de grille semi-conductrice ayant une épaisseur t_{Si2}, où t_{Si2} < t_{Si1} ;
- déposer une première couche de métal (11) ayant une épaisseur t_{M1} sur la première électrode de grille semi-conductrice du premier MOSFET ;
- déposer une seconde couche de métal ayant une épaisseur t_{M2} sur la seconde électrode de grille semi-conductrice du second MOSFET ;
- réaliser une première étape de procédé thermique pour siliciurer partiellement la première grille semi-conductrice du premier MOSFET pour former un siliciure Mₓ₁S_{y1} et pour siliciurer complètement la seconde grille semi-conductrice du second MOSFET pour former un siliciure Mₓ₂S_{y2} ;
- retirer sélectivement la fraction n'ayant pas réagi du métal déposé ; et
- réaliser une seconde étape de procédé thermique pour siliciurer complètement la première électrode de grille semi-conductrice partiellement siliciurée pour former un siliciure Mₓ₃S_{y3}.

2. Procédé selon la revendication 1, dans lequel x₂/y₂ > x₃/y₃.

3. Procédé selon la revendication 1 ou 2, dans lequel la réalisation de la première étape de procédé thermique comprend la sélection d'un bilan thermique pour siliciurer partiellement la première électrode de grille du premier MOSFET et pour siliciurer complètement la seconde électrode de grille du second MOSFET.

4. Procédé selon l'une quelconque des revendications 1 à 3, dans lequel les première et seconde couches de métal ont les mêmes compositions et épaisseur (t_{M2} - t_{M1}), et dans lequel, lors de la première étape de procédé thermique, le même siliciure est formé pour les premier et second MOSFET (x₁/y₁ = x₂/y₂).

5. Procédé selon l'une quelconque des revendications 1 à 4, dans lequel les première et seconde électrodes de grille semi-conductrices des premier et second MOSFET comprennent ou sont constituées de silicium.

6. Procédé selon la revendication 5, dans lequel les rapports d'épaisseur t_{M1}/t_{Si1} et t_{M2}/t_{Si2} sont choisis de sorte que le rapport de pourcentage atomique métal-semi-conducteur est supérieur à un pour le premier MOSFET et supérieure à deux pour le second MOSFET.

7. Procédé selon la revendication 6, dans lequel le rapport de pourcentage atomique métal-semi-conducteur de la première électrode de grille partiellement siliciurée du premier MOSFET est supérieur à un et inférieur à deux.

8. Procédé selon l'une quelconque des revendications 5 à 7, dans lequel lesdites première et seconde couches de métal comprennent ou sont constituées de nickel.

9. Procédé selon la revendication 8, dans lequel x₁/y₁ est égal à x₂/y₂ et supérieur à 1 (à savoir x₁/y₁ ≈ x₂/y₂ > 1) .

10. Procédé selon la revendication 9, dans lequel x₂/y₂ est supérieur à 2 et inférieur ou égal à 3 et dans lequel x₃/y₃ est égal à 1 (à savoir 2 < x₂/y₂ ≤ 3 et x₃/y₃ ≈ 1).

11. Procédé selon la revendication 1, dans lequel ladite première couche de métal et ladite seconde couche de métal sont une même couche de métal, ayant une épaisseur constante, déposée sur chacune desdites électrodes de grille semi-conductrices, dans lequel le siliciure formé a un rapport métal-semi-conducteur supérieur à 1, et par lequel lesdits premier et second MOSFET ont un travail d'extraction différent.

12. Procédé selon la revendication 11, dans lequel le dispositif à grille double complètement siliciurée est un dispositif CMOS, et le MOSFET avec l'électrode de grille semi-conductrice plus épaisse est un nMOSFET et le MOSFET avec l'électrode de grille semi-conductrice plus mince est un pMOSFET.

13. Procédé selon la revendication 11 ou 12, dans lequel le rapport de pourcentage atomique métal-semi-conducteur de l'électrode de grille complètement siliciurée formée après ladite seconde étape thermique est inférieur, au moins au fond du diélectrique de grille, au rapport de pourcentage atomique métal-semi-conducteur de l'électrode de grille partiellement siliciurée formée après ladite première étape thermique.

14. Procédé selon l'une quelconque des revendications 11 à 13, dans lequel lesdites électrodes de grille semi-conductrices comprennent ou sont constituées de silicium.

15. Procédé selon l'une quelconque des revendications 11 à 14, dans lequel ladite couche de métal comprend ou est constituée de nickel.

16. Procédé selon la revendication 15, dans lequel ledit siliciure obtenu après ladite première étape thermique est un siliciure NiₓSi_{y}, où x et y sont des nombres entiers, avec 2 ≤ x/y ≤ 3.

17. Procédé selon l'une quelconque des revendications 11 à 16, dans lequel lesdites première et seconde étapes thermiques sont des étapes de traitement thermique rapide, respectivement RTP1 et RTP2.

18. Procédé selon la revendication 17, dans lequel l'épaisseur de ladite électrode de grille pMOS est inférieure à 100 nm, de préférence comprise entre 20 nm et 75 nm, de manière davantage préférée comprise entre 25 nm et 50 nm.

19. Procédé selon la revendication 17 ou 18, dans lequel l'épaisseur de ladite électrode de grille nMOS est de 100 nm, de préférence comprise entre 50 nm et 100 nm, de manière davantage préférée comprise entre 50 nm et 75 nm.

20. Procédé selon la revendication 19, dans lequel les températures RTP1 sont comprises entre 250° et 675 °C, de préférence entre 350° et 675 °C, pendant 15 à 60 secondes.

21. Procédé selon la revendication 19 ou 20, dans lequel les températures RTP2 sont comprises entre 350° et 700 °C, pendant 15 à 60 secondes.

22. Procédé selon la revendication 19, dans lequel les températures RTP1 sont comprises entre 350° et 675 °C pendant 30 secondes et la température RTP2 est de 480 °C pendant 30 secondes.
